# FASCICULE DE BREVET EUROPEEN

(11) **EP 0 428 458 B1**
(45) Date de publication et mention de la délivrance du brevet: **13.03.1996**
(21) Numéro de dépôt: 90420490.6
(22) Date de dépôt: 14.11.1990
(51) Int. Cl.: C04B 41/88, C04B 41/90, F16J 15/12, H05K 5/00, H01L 23/36, H05K 9/00

(54) **Matériau multicouche comprenant du graphite souple renforcé mécaniquement, électriquement et thermiquement par un métal et procédé de fabrication**
Mehrschichtmaterial, das weichen Graphit enthält und das mit einem Metall mechanisch, elektrisch und thermisch verstärkt ist und das Verfahren zu seiner Herstellung
Multilayer material containing soft graphite, said material being mechanically, electrically and thermally reinforced by a metal and method of producing it

(30) Priorité: 16.11.1989 FR 8915741
(43) Date de publication de la demande: 22.05.1991
(73) Titulaire: LE CARBONE LORRAINE, F-92400 Courbevoie (FR)
(72) Inventeur: Colombier, Gabriel, F-38120 St Egreve (FR); Gimenez, Philippe, F-38130 Echirolles (FR); Drapier, Claude, F-92420 Vaucresson (FR); Moreau, Michel, F-92110 Clichy (FR)
(74) Mandataire: Mougeot, Jean-Claude

(56) Documents cités:
- FR-A- 1 362 054
- GB-A- 2 112 569
- GB-A- 2 154 675
- US-A- 3 010 189
- US-A- 3 264 198
- US-A- 3 404 061
- US-A- 3 476 586
- US-A- 4 647 714

## Description

### DOMAINE DE L'INVENTION

La présente invention concerne un matériau multicouche souple, comprenant du graphite expansé recomprimé renforcé par un métal, destiné soit à la fabrication de joints d'étanchéité, soit à la protection contre les rayonnements électromagnétiques, soit à la réalisation de drains thermiques, ainsi que son procédé de fabrication.

### ETAT DE LA TECHNIQUE

On connaît l'intérêt du graphite expansé recomprimé, communément appelé graphite souple, dans de nombreuses applications et notamment comme matériau pour joint d'étanchéité. Cependant, un des problèmes que pose l'utilisation de ce matériau est sa faible résistance mécanique, de sorte qu'on a cherché à renforcer le graphite souple par une couche de métal.

Ainsi, le brevet allemand n° 33 09 338 décrit un matériau multicouche pour joint d'étanchéité comprenant un renfort métallique central, sous forme d'une bande d'acier ou d'aluminium, deux couches de graphite souple de part et d'autre du renfort métallique, chaque couche de graphite recouvrant une face du renfort métallique et étant rendue solidaire de celle-ci grâce à une couche d'adhésif.

De même, le brevet européen n° 155 083 décrit une bande multicouche pour joint d'étanchéité comprenant un renfort métallique central constitué d'une bande de fer ou de nickel électroformé de faible épaisseur, la liaison entre le renfort et les couches de graphite souple étant assurée par un adhésif ou éventuellement par l'emploi d'un renfort métallique percé de trous de manière que, par endroits, les deux couches de graphite souple, qui sont auto-adhérentes, soient en contact.

Ainsi, selon l'art antérieur, la liaison entre les couches de graphite souple et la bande de renfort métallique est assurée soit par un adhésif soit par des moyens mécaniques. Il est des applications, de plus en plus nombreuses, qui exigent des matériaux de grande stabilité chimique, thermique et dimensionnelle, utilisés dans des conditions de température, de pression, d'agressivité chimique ou de non-contamination telles que l'emploi d'un adhésif doit être limité, si ce n'est prohibé. En effet, les adhésifs sont des produits susceptibles de fluer, d'être dégradés par exemple, par attaque chimique ou thermiquement.

Par ailleurs, l'emploi d'un renfort métallique percé de trous ne constitue pas une solution satisfaisante à ce problème pour trois raisons :
- elle ne permet pas de faire varier indépendammment l'une de l'autre, l'adhérence entre les couches de graphite souple et la tenue mécanique de la bande multicouche (plus il y aura de trous, plus l'adhérence entre les couches de graphite sera élevée, mais plus la tenue mécanique de la bande sera faible).
- un joint, obtenu à partir d'un tel matériau, est hétérogène en épaisseur puisque localement il peut y avoir ou non une épaisseur de renfort métallique, ce qui n'est pas favorable à l'étanchéité.
- elle se prête mal à une fabrication en continu.

On sait par ailleurs que la protection des équipements électroniques contre les rayonnements électromagnétiques consiste à réaliser des parois conductrices continues, par exemple en appliquant des revêtements de type peintures conductrices sur les enceintes en plastique ou sur les murs de salle à protéger, ou en utilisant des joints en élastomères conducteurs au niveau des discontinuités que constituent notamment les écrans de visualisation.
Dans cette application, l'efficacité de la protection, qui est caractérisée par la mesure de l'atténuation des ondes au cours de la traversée du blindage, peut être estimée à partir de la mesure de sa résistance électrique puisque l'atténuation d'absorption est proportionnelle à la racine carré de la conductivité électrique de la couche. En pratique, on utilise couramment la "résistance par carré", symbolisée par R_{□}, qui est égale au quotient de la résistivité par l'épaisseur du revêtement. Ainsi, dans le cas de peintures au nickel qui permettent d'atteindre des atténuations comprises entre 30 et 65 dB, la résistance par carré est généralement comprise respectivement entre 2000 et 400 mΩ pour une épaisseur de 25 µm.
Enfin, le refroidissement de cartes céramiques doit faire appel à des matériaux qui présentent simultanément une bonne conductivité thermique et un faible coefficient de dilatation. Un tel compromis de caractéristiques est obtenu par exemple avec un colaminé cuivre - invar - cuivre dont la rigidité n'est toutefois pas compatible avec la fragilité de la céramique si bien qu'il en résulte généralement un contact entre les deux matériaux n'autorisant pas un bon transfert thermique.

### OBJET DE L'INVENTION

L'invention a pour premier objet un matériau multicouche à base de graphite souple renforcé par un métal en vue d'améliorer sa résistance mécanique et dans certains cas de réduire sa résistance électrique ou d'améliorer sa conductivité thermique, ce qui permet de l'utiliser notamment pour la fabrication de joints d'étanchéité à teneur réduite, voire nulle, en adhésif, comme matériaux économiques de blindage contre les rayonnements électromagnétiques ou comme drains thermiques particuliers.

Une feuille de graphite souple d'épaisseur 0,2 mm, qui présente une résistance par carré de 50 à 60 mΩ, ce qui, du seul point de vue électrique, conviendrait au blindage, ne peut être utilisée pour cette application en raison de sa tenue mécanique insuffisante. De la même façon, une feuille mince de cuivre de 5 µm d'épaisseur, dont la résistance par carré est de 3,5 mΩ conviendrait parfaitement du point de vue électrique, mais son application soit directement sur la paroi intérieure des enceintes en matière plastique, soit à la surface d'un film souple en plastique est délicate à mettre en oeuvre ou même onéreuse. L'association des deux éléments graphite souple et feuille mince de métal conducteur, typiquement le cuivre, permet alors d'obtenir simultanément, et dans des conditions économiques, une faible résistance électrique et une grande facilité de manipulation.
Cette même association graphite souple - cuivre présente par ailleurs un ensemble de propriétés intéressantes : une bonne conductivité thermique, un faible coefficient de dilatation et une grande souplesse. Cet ensemble de caractéristiques convient particulièrement bien aux transferts thermiques.

Un autre objet de l'invention est un procédé de fabrication économique de matériaux multicouches à base de graphite souple renforcé par un métal.

### DESCRIPTION DE L'INVENTION

Selon l'invention, le matériau multicouche est constitué d'au moins deux couches de matériaux souples dont l'une, désignée par la lettre C dans cette description, est à base de graphite expansé recomprimé et dont l'autre est une couche de métal, caractérisé en ce que, au moins une des faces de la couche de matériau C à base de graphite souple électroconducteur est recouverte en tous points de sa surface d'une couche de métal M et est en contact électrique direct avec cette couche de métal M, en ce que cette couche de métal M est obtenue par électrodéposition ou par dépôt chimique de métal M sur ladite couche de matériau C, de manière à ce que le métal M adhère directement à la couche de matériau C et en épouse le micro-relief et présente une adhérence à la couche de matériau C supérieur à la cohésion interne de ladite couche matériau C;
Par commodité, un même symbole désignera, dans cette demande, un matériau et la couche constituée de ce matériau.

Selon l'invention, le matériau C est du graphite souple électroconducteur, connu par exemple sous le nom de PAPYEX, marque déposée (R) par la société Le Carbone Lorraine, de densité comprise entre 0,3 et 1,5 et ayant une épaisseur comprise entre 0,1 et 10 mm, selon l'utilisation finale. Ce matériau est fabriqué industriellement et se présente sous forme de bande bobinée de grande longueur et de largeur pouvant dépasser 1 m.

Le métal M qui est déposé sur la couche de matériau souple C est choisi parmi les métaux électrodéposables ou déposables par voie chimique. Si l'utilisation finale exige du métal M une bonne résistance à la corrosion, le nickel sera choisi de préférence, dans le cas contraire, d'autres métaux conviendront également: le cuivre, le zinc, le fer...etc. Le nickel est préféré dans l'application joint d'étanchéité alors que le cuivre, meilleur conducteur électrique et thermique, sera de préférence retenu pour les applications blindage électromagnétique ou drain thermique.

L'épaisseur de la couche de métal M est adaptée soit à la tenue mécanique recherchée soit à la conductivité électrique ou thermique désirée. Elle est généralement comprise entre 1 et 200 µm et de préférence entre 3 et 50 µm. Par exemple, si l'on désire un matériau ayant des caractéristiques mécaniques élevées, on augmentera l'épaisseur de la couche de métal M, et réciproquement, on la choisira mince si on privilégie la souplesse du matériau multicouche.
S'il s'agit d'utiliser les caractéristiques électriques du matériau multicouche pour le blindage, il apparaît qu'une couche de cuivre de quelques µm suffit à réduire la résistance initiale du graphite souple, de sorte qu'il est superflu, du seul point de vue électrique, de déposer plus de 5 µm de cuivre ou plus de 15 µm de nickel.

On constate que l'adhérence du métal M électrodéposé ou déposé par voie chimique sur la couche de matériau souple C est excellente et est supérieure à la cohésion interne de la couche C, aux densités usuel les de cette dernière : l'adhérence intercouche du matériau multicouche M/C est plus grande que la cohésion interne du matériau C, (M/C représente la succession des couches de matériaux selon l'axe perpendiculaire au plan de la bande de matériau multicouche et désigne cette bande de matériau multicouche elle-même).

Les matériaux multicouches de type C/M ou M/C/M peuvent être utilisés tels quels en tant que matériau pour joints d'étanchéité, pour le blindage électromagnétique ou le drainage thermique, cependant dans certains cas, de meilleurs résultats seront obtenus avec des matériaux multicouches plus complexes comportant un plus grand nombre de couches.

Dans ce but, au moins une des deux faces d'un matériau multicouche de type C/M ou M/C/M est revêtu d'une couche de liaison L, d'épaisseur comprise entre 1 et 10 µm, de façon à pouvoir rendre solidaire ladite face avec une autre couche soit de métal M soit de matériau souple C.

Selon une première modalité de l'invention, la couche de liaison L est constituée d'un métal LM ayant iin point de fusion inférieur à celui du métal M servant de renfort, la couche de métal LM étant déposée par tout moyen connu sur au moins une des faces des matériaux multicouches C/M ou M/C/M obtenus précédemment de manière à avoir les matériaux multicouches suivants : C/M/LM, LM/C/M, LM/C/M/LM, LM/M/C/M, LM/M/C/M/LM. L'épaisseur de la couche de métal LM peut être très faible, comprise entre 1 et 5 µm, cette couche ne jouant pas un rôle de matériau de structure destiné à conférer des caractéristiques mécaniques, mais seulement un rôle de couche de liaison ou de protection contre l'oxydation du métal M.

Le métal de liaison LM est choisi en fonction du métal de renfort M. Si ce dernier est du nickel ou du cuivre, on peut prendre comme métal de liaison, l'étain ou un alliage de brasure tendre contenant par exemple de l'étain, du plomb, de l'indium.

Les matériaux multicouches dont au moins une des faces est constituée de métal de liaison LM peuvent aussi être utilisés en tant que tels comme matériaux pour joints d'étanchéité, comme matériaux de blindage électromagnétique ou comme drain thermique. Ainsi, par exemple, on peut les appliquer sur un support métallique et les faire adhérer à ce support par chauffage et légère pression obtenus par exemple avec un fer à repasser.

Cependant, dans l'application comme matériau pour joint d'étanchéité en particulier, l'association de plusieurs couches de matériau souple C peut être souhaitable, notamment pour obtenir un matériau multicouche dont les deux faces externes sont en matériau souple C, matériau plus inerte chimiquement que les métaux.

Pour illustrer quelques possibilités d'association, on peut citer les matériaux multicouches suivants : C/M/LM/C, C/LM/C/M, C/LM/C/M/LM/C, C/LM/M/C/M, C/LM/M/C/M/LM/C, C/M/LM/M/C, C/M/LM/C/LM/M/C, C/M/LM/C/M/LM/C, C/LM/C/M/LM, C/LM/M/C/LM.

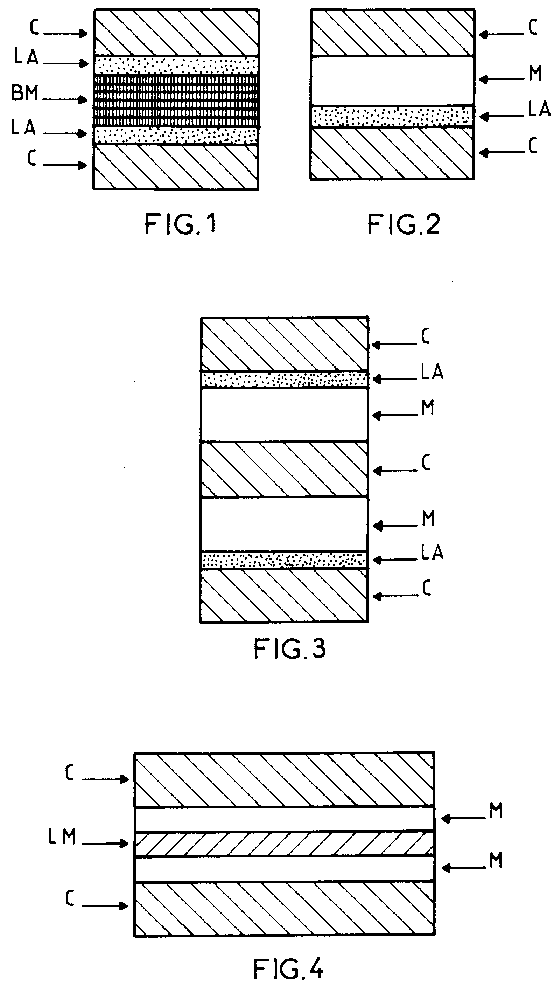

La figure 4 illustre le matériau multicouche C/M/LM/M/C. La figure 6 illustre le matériau multicouche C/M/LM/C. La figure 7 illustre le matériau multicouche C/LM/M/C/M/LM/C.

Cette première modalité de l'invention permet d'obtenir un matériau multicouche totalement exempt de matière organique thermolabile.

Selon une seconde modalité de l'invention, la couche de liaison L est une couche d'adhésif LA capable de faire adhérer une couche de métal M et une couche de matériau souple C. L'adhésif LA est choisi parmi les adhésifs connus pour adhérer sur les surfaces carbonées, sur les métaux et alliages et est de préférence à base de résine phénolique, époxy, polyimide, acrylique, polyuréthane. On obtient ainsi les matériaux multicouches suivants par dépôt d'adhésif LA sur au moins une face des matériaux multicouches C/M ou M/C/M : LA/C/M, C/M/LA, LA/C/M/LA, LA/M/C/M, LA/M/C/M/LA. L'épaisseur de la couche est comprise entre 10 et 1 µm et sera de préférence inférieure à 5 µm.

Généralement, ces matériaux multicouches ayant au moins une des deux faces recouverte d'une couche d'adhésif LA ne sont pas manipulables tels quels et sont collés à une couche de matériau souple C, qui peut être différente de la couche initiale de matériau souple C par l'épaisseur et/ou la densité, pour donner les matériaux multicouches suivants C/LA/C/M, C/LA/M/C/M, C/LA/C/M/LA/C, C/LA/M/C/M/LA/C.
Cependant, on peut choisir comme adhésif LA un adhésif de type "hot-melt", c'est à dire applicable à chaud et donnant après refroidissement une couche non-adhésive et donc manipulable, mais réactivable par réchauffage.
Dans ce cas, les matériaux multicouches ayant une couche externe d'adhésif LA sont manipulables et stockables.
La figure 2 illustre le matériau multicouche C/M/LA/C.
La figure 3 illustre le matériau multicouche C/LA/M/C/M/LA/C.

Les matériaux multicouches selon l'invention se présentent sous forme de bande enroulée en bobine ou sous forme de formats empilables, selon l'usage final et selon la souples se du matériau multicouche. Pour la plupart des applications envisagées, le matériau multicouche en bande ou format sera soumis à une opération de découpage ultérieure. Mais dans le cas du blindage électromagnétique d'enceintes ou de salles, le matériau multicouche pourra être utilisé tel quel en juxtaposant des bandes successives comme s'il s'agissait de papier peint.

Pour faciliter le travail de l'utilisateur, il importe que le matériau multicouche soit pourvu des moyens qui permettent son positionnement ou sa fixation sur le support choisi par l'utilisateur final. Dans ce but, le matériau multicouche de l'invention peut avoir une couche externe d'adhésif permettant sa fixation sur les matériaux usuels : matériaux plastiques, verre, métal, bois, plâtre, papier etc..., et dans ce cas, le matériau multicouche de l'invention peut se présenter comme un ruban adhésif du commerce.
L'adhésif peut être du type "hot-melt", et dans ce cas, le matériau multicouche, par exemple en formats, non collant à la température ambiante, peut être appliqué sur le support choisi par l'utilisateur par exemple à l'aide d'un fer à repasser.
Une autre manière de procéder consiste à déposer une couche externe d'adhésif actif à la température ambiante et à le recouvrir d'un film pelable de manière à pouvoir soit l'enrouler en bobine s'il s'agit de bande, soit l'empiler s'il s'agit de formats sans qu'il y ait de problème de collage au déroulage ou au dépilage. On peut utiliser comme matériau du film pelable le papier ou une matière plastique.

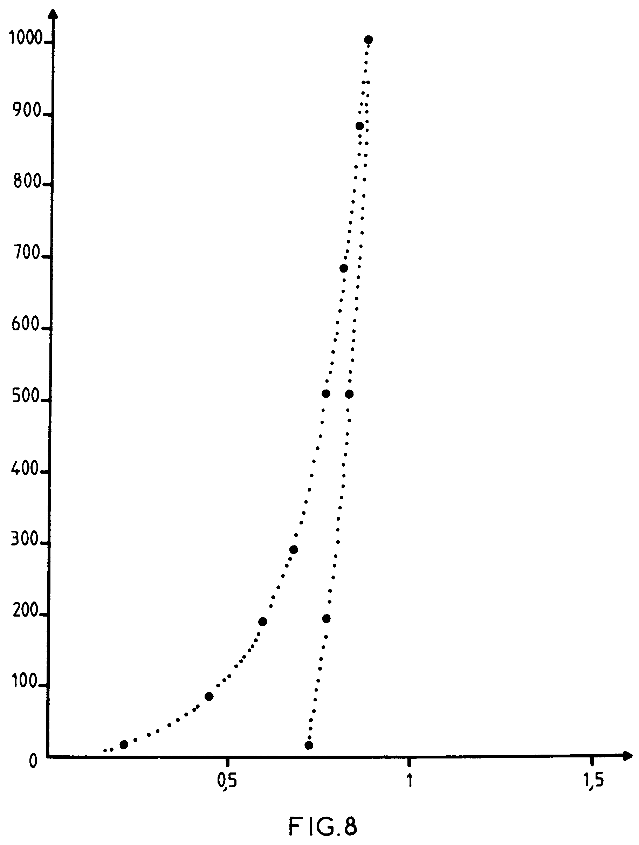

Les matériaux multicouches selon l'invention permettent d'obtenir des joints d'étanchéité présentant une excellente résistance à l'écrasement. Voir par exemple la courbe d'écrasement (figure 8) d'un joint obtenu avec le matériau préparé à l'exemple 1.

Les matériaux selon l'invention sont particulièrement bien adaptés à la fabrication de joints de blindage électromagnétique utilisés par exemple au niveau des discontinuités telles que les systèmes d'ouverture ou les écrans de visualisation. Ils peuvent également être mis en oeuvre pour recouvrir les murs d'une salle lorsqu'on veut la transformer en cage de Faraday.

Les matériaux selon l'invention conviennent particulièrement bien à la réalisation de drains thermiques constitués par exemple d'un format de matériau multicouche souple de type M/C/M ou LM/M/C/M/LM sur les deux faces duquel on applique ou on brase deux cartes céramiques à refroidir.

L'invention a pour second objet un procédé de fabrication économique de matériau multicouche, que celui-ci soit sous forme de bande ou de format.

Selon l'invention, on dépose le métal M sur au moins une face d'une couche de matériau souple C, généralement sous forme de bande.
Ce dépôt peut être réalisé par électrodéposition : une couche de métal M est déposée sur le matériau souple C électroconducteur qui sert de cathode, par réduction électrolytique d'un sel soluble de ce métal M contenu dans le bain : dans le cas du dépôt de nickel, on peut utiliser du sulfamate de nickel mais d'autres sels conviennent également. Cette technique de dépôt est connue en elle-même et décrite dans "Techniques de l'ingénieur" - M 1610. On peut ainsi obtenir les produits C/M et M/C/M selon qu'il y a eu dépôt sur une ou sur les deux faces de la couche de produit souple C.
Les densités de courant appliquées peuvent varier dans une large gamme et influent sur la vitesse de dépôt du métal. Le temps de traitement est choisi de façon à obtenir l'épaisseur de métal requise.

On peut aussi réaliser le dépôt de métal par voie chimique. Dans ce cas, la réduction du cation du métal à déposer se fait par un agent chimique réducteur. Dans le cas du dépôt de nickel, les réducteurs les plus courants sont l'hypophosphite, les composés du bore, l'hydrazine ou ses sels.

Ces dépôts, par électrodéposition ou par voie chimique, sont de préférence réalisés sur une bande de graphite souple (matériau C) de largeur pouvant dépasser 1 m et avec une régulation et un contrôle automatique des paramètres chimiques et/ou électriques du bain ainsi que de la vitesse de défilement de la bande de manière à obtenir une couche de métal M d'épaisseur régulière et prédéterminée.

En vue de fabriquer des matériaux multicouches mieux adaptés à leur utilisation finale, on peut revêtir de métal de liaison LM, au moins une face des matériaux multicouches M/C ou M/C/M. Pour cela, le métal de liaison LM peut être déposé par électrodéposition dans un bain contenant un sel soluble du métal LM, comme décrit dans "Techniques de l'ingénieur" - M 1620 et 2020 dans le cas de l'étain.

On peut aussi réaliser un dépôt par voie chimique, dans le cas de l'étain notamment. Que le dépôt de métal LM ait lieu par voie chimique ou électrochimique, il est avantageux , comme dans le cas du dépot de métal M, de le réaliser en continu avec un contrôle automatique du bain, et sur des bandes de grande largeur pouvant dépasser 1 m de large.Les bains de dépôt électrolytique ou de dépôt chimique de métal M et de métal LM peuvent être avantageusement disposés en série.
On peut obtenir ainsi les matériaux multicouches suivants : C/M/LM, LM/C/M, LM/C/M/LM, LM/M/C/M, LM/M/C/M/LM.

Il existe d'autres techniques de dépôt de métal M ou LM utilisables pour réaliser l'invention, telles que l'immersion en bain métallique fondu ou encore le dépôt par pulvérisation de métal liquide, par projection thermique, les dépôts sous vide, la CVD (chemical vapour deposition) mais souvent ces techniques ne permettent pas de traiter en continu une bande de grande largeur, ou ne permettent pas de maîtriser les faibles épaisseurs requises, en outre, elles sont souvent plus onéreuses que les techniques préférées de l'invention.

Dans le cas où la liaison est réalisée par adhésif LA, le dépôt de la couche d'adhésif LA est réalisée par tout procédé connu, par exemple par enduction suivie de collage, de manière à obtenir en un seul passage de la bande, par exemple le produit C/M/LA/C à partir d'une bande de C/M et une bande de C, réalisant ainsi le dépôt et l'assemblage. Dans le cas d'un multicouche comportant deux couches d'adhésif LA, on réalise une application double face et un assemblage par collage des différentes parties du matériau multicouche : ainsi, par exemple, C/LA/M/C/M/LA/C est obtenu en un seul passage par application de l'adhésif LA sur les deux faces de M/C/M, suivie du collage en ligne d'une couche de matériau souple C sur chaque face.

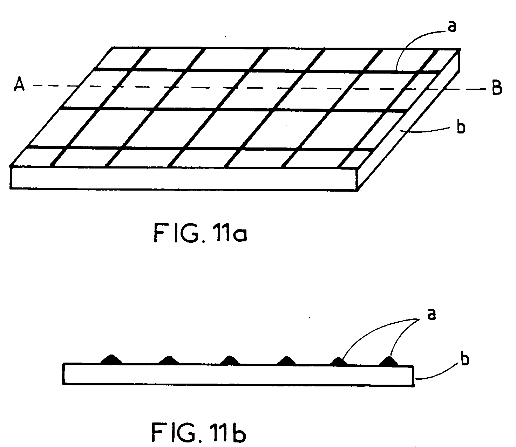

IL est possible cependant d'effectuer un dépôt d'adhésif LA sans le faire suivre directement d'une phase de collage. Dans ce cas, l'adhésif est du type "hot-melt". Ce cas de figure peut se présenter lorsque l'on applique l'adhésif sur bande de manière continue et qu'il est nécessaire d'effectuer l'assemblage et collage final en formats, de manière discontinue, par exemple à cause d'une épaisseur finale du matériau multicouche trop grande.
De préférence, on dépose l'adhésif LA, quelle que soit sa nature chimique, en continu et avec un contrôle et une régulation de l'épaisseur déposée. On peut déposer une couche d'adhésif LA, continue dans le plan, par enduction ou pulvérisation.
Mais il peut être préférable d'avoir une couche d'adhésif discontinue, mais régulièrement répartie, ayant typiquement l'aspect d'un grillage à maille fine, chaque maille ayant un côté, dans le cas d'une forme carrée, pouvant être compris entre 0,1 et 10 mm, de manière à avoir un taux de recouvrement par l'adhésif LA compris entre 5 et 50% de la surface à recouvrir. Voir figure 11.
Ce type de dépot discontinu est typiquement réalisé par sérigraphie. Les avantages d'un dépot discontinu à maillage sont les suivants : - diminution du grammage d'adhésif déposé, intéressant à la fois comme économie de matière coûteuse et comme diminution du risque de pollution par les matières organiques portées à haute température.
- le maillage fin conduit à la formation d'un très grand nombre de petites "cuvettes", dont le rebord est constitué par l'adhésif LA, isolées les unes des autres de sorte que l'étanchéité avec ce type de dépot est supérieure à celle obtenue avec un dépot d'épaisseur uniforme, un chemin de fuite préférentiel n'étant jamais exclu dans ce dernier cas.

Les matériaux multicouches dont au moins une face est constituée d'une couche de liaison LM ou LA sont assemblés avec au moins une couche de matériau souple C, parfois avec eux-mêmes, de manière que la couche de liaison LM ou LA devienne une couche interne, mais, avec certains types d'adhésifs LA, le dépot et l'assemblage sont réalisés quasi simultanément comme cela a été mentionné précédemment.
D'une manière générale, l'assemblage est obtenu, soit en continu, par passage des matériaux à assembler, sous forme de bande, entre des cylindres presseurs, soit de manière discontinue à la presse à partir de matériaux à assembler découpés en formats, avec une pression d'assemblage comprise entre 1 et 100 MPa selon les techniques d'assemblage et les matériaux à assembler, et une température d'assemblage inférieure à 600°C dans le cas d'une couche de liaison de type LM, et inférieure à 300°C dans le cas d'une couche de liaison de type LA.

L'assemblage discontinu est réalisé à la presse à une température légèrement supérieure à la température de fusion du métal LM ou d'activation de l'adhésif LA. Par exemple, cette température est de 240°C lorsque le métal LM est de l'étain, qui fond à 232°C. La pression d'assemblage est de l'ordre de 30 MPa.
L'assemblage continu est réalisé en faisant passer l'ensemble des couches du matériau multicouche, éventuellement préchauffées, entre deux cylindres chauffés et exerçant une pression de manière à avoir localement sensiblement les mêmes conditions de température et de pression que dans l'assemblage discontinu.

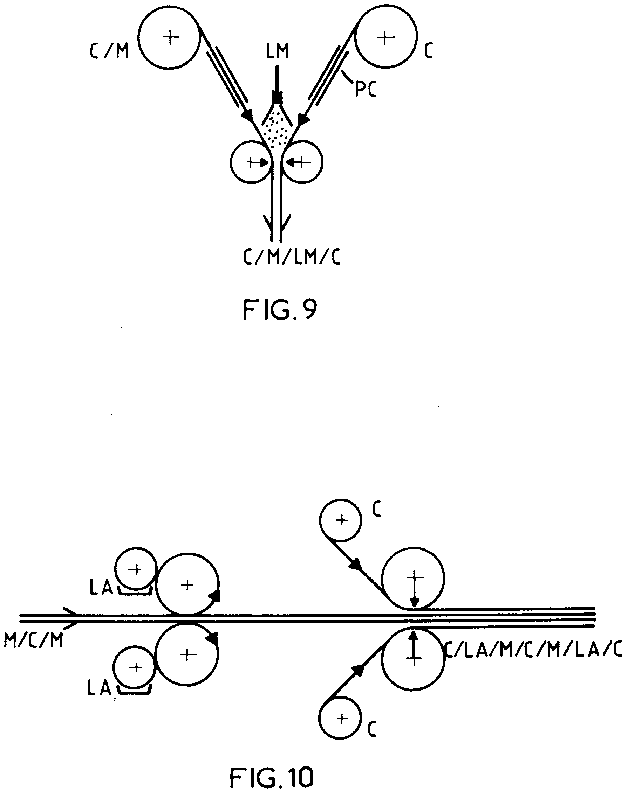

Dans le cas d'un métal de liaison LM, il est également possible selon l'invention de réaliser simultanément le dépôt de métal LM et l'assemblage des diverses couches par pulvérisation de métal liquide fondu entre les couches à assembler, au préalable préchauffées, suivi du refroidissement de l'ensemble. Voir figure 9.

D'une manière générale, l'épaisseur du matériau multicouche varie peu par suite de la compression dans la mesure où la pression appliquée n'est pas supérieure à celle déjà subie par le matériau souple C.

Dans le cas de matériaux multicouches obtenus selon l'invention et comportant sur une des deux faces un adhésif destiné à faciliter, pour l'utilisateur final, le positionnement du matériau multicouche ou du joint obtenu à partir de ce matériau, il est avantageux, comme dans le cas du dépot d'adhésif LA, de déposer une couche discontinue mais régulièrement répartie de cet adhésif, de préférence par une technique sérigraphique permettant d'obtenir un dépôt ayant l'aspect d'un grillage à maille fine, de manière à avoir un taux de recouvrement compris entre 5 et 50 % de la surface à recouvrir.
Ce procédé présente, en plus des avantages déjà mentionnés à propos du dépôt d'adhésif LA par la même technique, l'avantage de ne pas isoler électriquement la couche sous-jacente, ce qui est intéressant dans l'application blindage électromagnétique. En outre, quand cette couche externe d'adhésif est recouverte d'un film pelable, un film de faible épaisseur peut être utilisé sans être déchiré au pelage.

Le procédé selon l'invention présente de nombreux avantages et en particulier :
- il permet de déposer directement du métal M sur la couche de matériau souple C, ce qui permet d'éviter une couche de liaison, notamment une couche de liaison à base d'adhésif, ce qui est favorable dans de nombreuses applications.
- le dépôt direct de métal M sur la couche de matériau souple C permet au métal de suivre, d'épouser la microrugosité de surface du matériau souple C, ce qui contribue à une excellente adhérence entre ces deux couches, d'où une manipulation du matériau multicouche et du joint final sans risques de détérioration.
- le dépôt de métal LM permet d'obtenir un matériau multicouche sans aucun adhésif, ce qui ouvre des champs d' application nouveaux notamment lorsque les joints d'étanchéité doivent être utilisés à haute température et dans des conditions de noncontamination, dans l'industrie électronique par exemple. En outre, avec ce type de joint, le risque de fluage est totalement supprimé.
- les techniques de dépôt du métal M permettent de fournir à la demande et selon les besoins un matériau multicouche d'épaisseur de métal M optimum et d'épaisseur uniforme alors que l'art antérieur exige des stocks de bandes de métal de différentes épaisseurs.
- enfin, le procédé selon l'invention permet une grande productivité puisque :
- les différentes phases du procédé peuvent être réalisées en continu et en grande largeur, au moins égale à 1 m alors que les bandes de nickel électroformé sont disponibles en largeur n'excédant pas 50 cm.
- l'ensemble des phases du procédé peut être réalisé en ligne en un seul passage des diverses couches de matériau.
- les différentes phases du procédé sont facilement automatisables et régulables permettant un contrôle aisé de la qualité.

En définitive, l'invention permet la fabrication économique et souple de matériaux multicouches polyvalents par leur utilisation, qu'il s'agisse de matériaux pour joints d'étanchéité aux fluides, qu'il s'agisse d'étanchéité aux ondes électromagnétiques ou qu'il s'agisse de favoriser des transferts thermiques. Ces matériaux peuvent aussi satisfaire des exigences sévères notamment les exigences de non-contamination à des températures moyennes à élevées.

### DESCRIPTION DES FIGURES

Figure 1 - Elle schématise l'art antérieur : C/LA/BM/LA/C où BM désigne une bande de métal
Figure 2 - matériau multicouche selon l'invention C/M/LA/C où M désigne un métal électrodéposé ou déposé chimiquement sur C.
Figure 3 - matériau multicouche selon l'invention : C/LA/M/C/M/LA/C
Figure 4 - matériau multicouche selon l'invention : C/M/LM/M/C

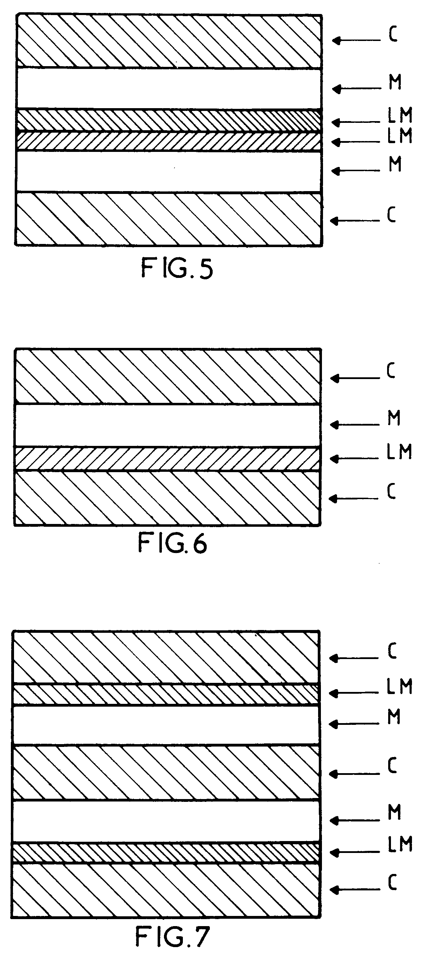

Figure 5 - matériau multicouche selon l'invention : C/M/LM/M/C obtenu à partir de C/M/LM
Figure 6 - matériau multicouche selon l'invention : C/M/LM/C
Figure 7 - matériau multicouche selon l'invention : C/LM/M/C/M/LM/C
Figure 8 - courbe caractéristique d'un joint (grand diamètre = 149 mm, petit diamètre = 129 mm, épaisseur = 1,5 mm) obtenu à partir du matériau multicouche de l'exemple 1 (C/LA/M/C/M/LA/C). En abscisse figure l'écrasement en mm, en ordonnée figure la pression de serrage en daN/cm2 (ou bar = 10⁵Pa).
Figure 9 - dépôt de métal LM par pulvérisation de métal LM liquide et assemblage simultané de C et de C/M, préchauffés dans un four de préchauffage PC. En aval des rouleaux presseurs, la bande multicouche C/M/LM/C est refroidie (non figuré sur le schéma).
Figure 10 - enduction double face avec l'adhésif LA, de M/C/M, suivi du collage sur chaque face de C, de manière à obtenir le matériau multicouche C/LA/M/C/M/LA/C.
Figure 11 - la figure 11-a schématise un dépot d'adhésif (a) en forme de grillage par une technique sérigraphique sur un support (b). La figure 11-b est une vue en coupe selon la droite AB de la figure 11-a.

### EXEMPLES

### Exemple 1

Dans un bain de nickelage au sulfamate de nickel, on a déposé sur chaque face d'une feuille de graphite souple (Papyex - marque déposée) de 0,5 mm d'épaisseur, une couche de nickel de 10 µm. Chaque face de la feuille ainsi nickelée a été enduite d'un adhésif à base de résine époxy, sur lequel on a appliqué une feuille de graphite souple de 0,5 mm d'épaisseur (figure 3). On a ainsi un matériau de 1,5 mm d'épaisseur. Les tests d'écrasement sous 100 MPa ainsi que les tests d'étanchéité d'un joint réalisé avec ce matériau sont excellents (voir figure 8).

### Exemple 2

On a nickelé une feuille de graphite souple de 0,5 mm d'épaisseur sur une face à 10 µm comme dans l'exemple 1 puis on a étamé la face nickelée avec une épaisseur de 1 µm d'étain. On a assemblé une seconde feuille de graphite souple de 0,5 mm sur la feuille précédente (côté étain), à chaud, à 240°C et sous une pression de 30 MPa. Après refroidissement, on a obtenu un matériau de 1 mm d'épaisseur (voir figure 6). Les tests d'écrasement d'un joint réalisé avec ce matériau sont excellents sous 100 MPa.

### Exemple 3

On a nickelé deux feuilles de graphite souple de 0,5 mm d'épaisseur, chacune sur une face à 5 µm, puis on a étamé chaque face nickelée avec une épaisseur de 1 µm d'étain. On a ensuite pressé ces deux feuilles sous 30 MPa à 240°C, les faces étamées étant en contact l'une contre l'autre. Après refroidissement, on obtient un matériau multicouche de 1 mm d'épaisseur de structure C/M/ML/M/C. Voir figure 5.

### Exemple 4

On a nickelé une feuille de graphite souple de 0,5 mm d'épaisseur à 5 µm puis étamée à 1 µm sur ses deux faces. On a rapporté deux feuilles de graphite souple de 0,5 mm d'épaisseur de part et d'autre de la feuille de graphite nickelée et étamée. On a pressé ces trois feuilles sous 30 MPa à 240°C. Après refroidissement, on a obtenu un matériau multicouche de 1,5 mm d'épaisseur. Voir figure 7. Les tests d'écrasement sous 100 MPa de joints réalisés avec les matériaux des exemples 3 et 4 ont donné d'excellents résultats.

### Exemple 5

On a nickelé une feuille de graphite souple de 0,2 mm d'épaisseur à différentes épaisseur sur une face. On a mesuré ensuite la résitance R_{□} du matériau (résistance dans le sens parallèle à la feuille d'un carré de 50mm de côté):

| n ° d'essai | épaisseur Ni (µm) | R(mΩ) |
|---|---|---|
| 5-1 | 5 | 13,5 |
| 5-2 | 10 | 7,3 |
| 5-3 | 15 | 5,0 |

Ces matériaux conviennnent pour le blindage électromagnétique et comme drain thermique.

### Exemple 6

Il diffère seulement de l'exemple 5 en ce que la feuille de graphite souple a une épaisseur de 0,5 mm au lieu de 0,2.

| n ° d'essai | épaisseur Ni (µm) | R(mΩ) |
|---|---|---|
| 6-1 | 5 | 12,0 |
| 6-2 | 10 | 6,8 |
| 6-3 | 15 | 4,3 |

Ces matériaux conviennent pour le blindage électromagnétique et comme drain thermique.

### Exemple 7

On a cuivré une feuille de graphite souple de 0,2 mm d'épaisseur à différentes épaisseurs sur une face, puis on a mesuré la résistance comme à l'exemple 5.

| n ° d'essai | épaisseur Cu (µm) | R(mΩ) |
|---|---|---|
| 7-1 | 2 | 49,0 |
| 7-2 | 5 | 3,3 |
| 7-3 | 7 | 2,3 |

Ces matériaux conviennent pour le blindage électromagnétique et comme drain thermique.

### Exemple 8

L'exemple 8 ne diffère de l'exemple 7 que par l'épaisseur de la feuille de graphite de 0,5 mm au lieu de 0,2 mm dans l'exemple 7.

| n ° d'essai | épaisseur Cu (µm) | R(mΩ) |
|---|---|---|
| 8-1 | 2 | 21,0 |
| 8-2 | 5 | 4,5 |
| 8-3 | 7 | 2,3 |

Ces matériaux conviennent pour le blindage électromagnétique et comme drain thermique.

## Revendications

1. Matériau multicouche constitué d'au moins deux couches de matériau souple dont l'une, désignée par "C", est à base de graphite expansé recomprimé et dont l'autre est une couche de métal, caractérisé en ce que, au moins une des deux faces de la couche de matériau C à base de graphite souple électroconducteur est recouverte en tout point de sa surface d'une couche de métal M et est en contact électrique direct avec cette couche de métal M, en ce que cette couche de métal M est obtenue par électrodéposition ou par dépôt chimique de métal M sur ladite couche de matériau C, de manière à ce que le métal M adhère directement à la couche de matériau C et en épouse le micro-relief et présente une adhérence à la couche de matériau C supérieure à la cohésion interne de ladite couche matériau C.

2. Matériau multicouche selon la revendication 1 dans lequel ledit matériau souple C est du graphite souple de densité comprise entre 0,3 et 1,5 en couche d'épaisseur comprise entre 0,1 et 10 mm.

3. Matériau multicouche selon la revendication 2 dans lequel ladite couche de métal M est constituée d'un ou plusieurs métaux déposables par voie chimique ou électrochimique.

4. Matériau multicouche selon la revendication 3 dans lequel l'épaisseur de la couche de métal déposé est comprise entre 1 et 200 µm et de préférence comprise entre 3 et 50 µm.

5. Matériau multicouche selon la revendication 4 dans lequel le métal M est du nickel ou du cuivre.

6. Matériau multicouche selon l'une quelconque des revendications 1 à 5 dont au moins une face est revêtue d'une couche de liaison L de façon à pouvoir rendre solidaire ladite face avec une autre couche soit de métal M soit de matériau souple C.

7. Matériau multicouche selon la revendication 6 dans lequel la couche de liaison L a une épaisseur comprise entre 1 et 10 µm.

8. Matériau multicouche selon la revendication 7 dans lequel ladite couche de liaison L est constituée d'un métal LM, ayant un point de fusion inférieur à celui du métal M servant de renfort, qui est déposé par tout moyen connu sur au moins une face des matériaux multicouches C/M ou M/C/M, de manière à obtenir un des matériaux multicouches suivants: C/M/LM, LM/C/M, LM/C/M/LM, LM/M/C/M, LM/M/C/M/LM

9. Matériau multicouche selon la revendication 8 dans lequel au moins une couche de liaison LM est recouverte d'une couche de matériau souple C de manière à obtenir, directement ou après assemblage, un des matériaux multicouches suivants : C/M/LM/C, C/LM/C/M, C/LM/C/M/LM/C, C/LM/M/C/M, C/LM/M/C/M/LM/C, C/M/LM/M/C, C/M/LM/C/LM/M/C, C/M/LM/C/M/LM/C, C/LM/C/M/LM, C/LM/M/C/LM.

10. Matériau multicouche selon l'une quelconque des revendications 7, 8 ou 9 dans lequel le métal de liaison LM est de l'étain.

11. Matériau multicouche selon la revendication 7 dans lequel ladite couche de liaison L est une couche d'adhésif LA, capable de faire adhérer la couche de métal M et la couche de matériau souple C, recouvrant au moins une face des matériaux multicouches C/M ou M/C/M de manière à obtenir un des matériaux multicouches suivants : LA/C/M, C/M/LA, LA/C/M/LA, LA/M/C/M, LA/M/C/M/LA.

12. Matériau multicouche selon la revendication 11 dans lequel chaque couche de liaison LA est recouverte d'une couche de matériau souple C de manière à obtenir, directement ou par assemblage, un des matériaux multicouches suivants : C/LA/C/M, C/M/LA/C, C/LA/C/M/LA/C, C/LA/M/C/M, C/LA/M/C/M/LA/C.

13. Matériau multicouche selon l'une quelconque des revendications 11 ou 12 dans lequel l'adhésif LA est à base de résine phénolique, époxy, polyimide, acrylique ou polyuréthane.

14. Matériau multicouche selon l'une quelconque des revendications 1 à 13 dont une face est recouverte d'une couche externe d'adhésif, qui peut être du type "hot-melt", d'épaisseur comprise entre 1 et 10 µm, destinée à rendre ledit matériau multicouche solidaire du support final sur lequel il est appliqué en vue de son utilisation.

15. Matériau multicouche selon la revendication 14 dont ladite couche externe d'adhésif est revêtue d'un film pelable en matériau non-adhésif en lui-même, de préférence du papier ou un film plastique, de façon à ne faire apparaître la fonction adhésive d'une face du matériau multicouche qu'au moment de son application sur ledit support final en enlevant le film pelable.

16. Procédé de fabrication de matériau multicouche selon l'une quelconque des revendications 1 à 5 dans lequel on dépose en continu le métal M par électrodéposition ou par voie chimique sur au moins une face d'une bande de matériau souple C de largeur pouvant dépasser 1 m avec une régulation et un contrôle automatique des paramètres chimiques et/ou électriques du bain ainsi que de la vitesse de défilement de la bande de manière à obtenir une couche de métal M d'épaisseur régulière et prédéterminée.

17. Procédé de fabrication de matériau multicouche selon l'une quelconque des revendications 8 et 10 dans lequel on dépose en continu et avec un contrôle et une régulation de l'épaisseur déposée, le métal de liaison LM par électrodéposition ou par voie chimique sur au moins une face de matériau multicouche C/M ou M/C/M en bande de largeur pouvant dépasser 1 m.

18. Procédé de fabrication de matériau multicouche selon l'une quelconque des revendications 11 et 13 dans lequel on dépose en continu et avec un contrôle et une régulation de l'épaisseur déposée, une couche d'adhésif LA par toute méthode connue et de préférence par enduction ou pulvérisation, sur au moins une face de matériau multicouche C/M ou M/C/M en bande de largeur pouvant dépasser 1 m.

19. Procédé de fabrication selon la revendication 18 dans lequel on dépose, de préférence par un procédé sérigraphique, une couche d'adhésif LA discontinue mais régulièrement répartie, de préférence à l'aspect de grillage à maille fine, de manière à avoir un taux de recouvrement par l'adhésif LA compris entre 5 et 50% de la surface à recouvrir.

20. Procédé de fabrication de matériau multicouche selon l'une quelconque des revendications 9 ou 12 dans lequel on réalise l'assemblage d'un matériau multicouche dont au moins une face est constituée d'une couche de liaison LM ou LA avec au moins une couche de matériau souple C, ou éventuellement avec lui-même, de manière que la couche de liaison LM ou LA devienne une couche interne, ledit assemblage étant obtenu soit en continu par passage des matériaux à assembler, sous forme de bande, entre des cylindres presseurs, soit en discontinu à la presse avec les matériaux à assembler découpés en formats, avec une pression d'assemblage comprise entre 1 et 100 MPa et une température d'assemblage inférieure à 600°C dans le cas d'une couche de liaison LM et inférieure à 300°C dans le cas d'une couche de liaison LA.

21. Procédé de fabrication de matériau multicouche selon l'une quelconque des revendications 14 ou 15 dans lequel l'adhésif est appliqué, de préférence par une technique sérigraphique, une couche discontinue mais régulièrement répartie, de préférence à l'aspect de grillage à maille fine, de manière à avoir un taux de recouvrement compris entre 5 et 50% de la surface à recouvrir.

22. Application des matériaux multicouches selon l'une quelconque des revendications 1 à 15 à la fabrication de joints d'étanchéité.

23. Application des matériaux multicouches selon l'une quelconque des revendications 1 à 15 au blindage électromagnétique.

24. Application des matériaux multicouches selon l'une quelconque des revendications 1 à 15 à la fabrication de drains thermiques.

## Claims

1. A multi-layer material constituted by at least two layers of flexible material, one of which, designated as "C", is based on recompressed expanded graphite, and the other of which is a layer of metal, characterised in that at least one of the two faces of the layer of material C based on electrically conductive flexible graphite is covered at every point of its surface by a layer of metal M and is in direct electrical contact with that layer of metal M, in that the layer of metal M is obtained by electrodeposition or by chemical deposit of metal M on said layer of material C, in such a way that the metal M directly adheres to the layer of material C, closely matches the micro-relief thereof, and has an adherence to the layer of material C which is greater than the internal cohesion of said layer of material C.

2. A multi-layer material according to Claim 1, wherein said flexible material C is flexible graphite of a specific gravity of between 0.3 and 1.5 in a layer of a thickness of between 0.1 and 10 mm.

3. A multi-layer material according to Claim 2, wherein said layer of metal M is constituted by one or more metals which can be deposited chemically or electrochemically.

4. A multi-layer material according to Claim 3, wherein the thickness of the layer of metal deposited is between 1 and 200 µm, and preferably between 3 and 50 µm.

5. A multi-layer material according to Claim 4, wherein the metal M is nickel or copper.

6. A multi-layer material according to any one of Claims 1 to 5, at least one face of which is covered with a bonding layer L in such a way that said face is able to be fixed to another layer either of metal M or of flexible material C.

7. A multi-layer material according to Claim 6, wherein the thickness of the bonding layer L is between 1 and 10 µm.

8. A multi-layer material according to Claim 7, wherein said bonding layer L is constituted by a metal LM having a melting point lower than that of the metal M used as a reinforcement, which is deposited by any known means on at least one face of the multi-layer materials C/M or M/C/M in such a way as to obtain one of the following multi-layer materials: C/M/LM, LM/C/M, LM/C/M/LM, LM/M/C/M, LM/M/C/M/LM.

9. A multi-layer material according to Claim 8, wherein at least one bonding layer LM is covered with a layer of flexible material C in such a way as to obtain, directly or after assembly, one of the following multi-layer materials: C/M/LM/C, C/LM/C/M, C/LM/C/M/LM/C, C/LM/M/C/M, C/LM/M/C/M/LM/C, C/M/LM/M/C, C/M/LM/C/LM/M/C, C/M/LM/C/M/LM/C, C/LM/C/M/LM, C/LM/M/C/LM.

10. A multi-layer material according to any one of Claims 7, 8 or 9, wherein the bonding metal LM is tin.

11. A multi-layer material according to Claim 7, wherein said bonding layer L is a layer of adhesive LA which is capable of making the layer of metal M adhere to the layer of flexible material C, covering at least one face of the multi-layer materials C/M or M/C/M in such a way as to obtain one of the following multi-layer materials: LA/C/M, C/M/LA, LA/C/M/LA, LA/M/C/M, LA/M/C/M/LA.

12. A multi-layer material according to Claim 11, wherein each bonding layer LA is covered with a layer of flexible material C in such a way as to obtain, directly or by assembly, one of the following multi-layer materials: C/LA/C/M, C/M/LA/C, C/LA/C/M/LA/C, C/LA/M/C/M, C/LA/M/C/M/LA/C.

13. A multi-layer material according to either one of Claims 11 or 12, wherein the adhesive LA is based on phenol, epoxy, polyimide, acrylic or polyurethane resin.

14. A multi-layer material according to any one of Claims 1 to 13, one face of which is covered with an external layer of adhesive which can be of the "hot-melt" type and of between 1 and 10 µm in thickness which is intended to fix said multi-layer material to the final support to which it is applied for the purposes of use thereof.

15. A multi-layer material according to Claim 14, of which said external layer of adhesive is covered with a peelable film of material which is non-adhesive in itself, preferably paper or a plastics film, so as to only cause the adhesive function of one face of the multi-layer material to appear at the moment when it is applied to said final support by lifting off the peelable film.

16. A process for the production of multi-layer material according to any one of Claims 1 to 5, wherein the metal M is deposited continuously by electrodeposition or chemically on at least one face of a strip of flexible material C of a width which can exceed 1 m with automatic monitoring and regulation of the chemical and/or electrical parameters of the bath as well as the speed of movement of the strip in such a way as to obtain a layer of metal M of regular, predetermined thickness.

17. A process for the production of multi-layer material according to either one of Claims 8 or 10, in which the bonding metal LM is deposited continuously and with monitoring and regulation of the deposited thickness by electrodeposition or chemically on at least one face of the multi-layer material C/M or M/C/M in the form of a strip whose width can exceed 1 m.

18. A process for the production of multi-layer material according to either one of Claims 11 or 13, wherein a layer of adhesive LA is deposited continuously and with monitoring and regulation of the deposited thickness, using any known method and preferably by coating or spraying, on at least one face of the multi-layer material C/M or M/C/M in the form of a strip which can exceed 1 m in width.

19. A production process according to Claim 18, wherein a layer of adhesive LA which is discontinuous but uniformly distributed is deposited, preferably by way of a screen printing process, preferably in the form of a fine-mesh grid, in such a way as to give a degree of covering of the surface to be covered by the adhesive LA of between 5 and 50%.

20. A process for the production of multi-layer material according to either one of Claims 9 or 12, wherein a multi-layer material, at least one face of which is constituted by a bonding layer LM or LA, is assembled to at least one layer of flexible material C, or possibly to itself, in such a way that the bonding layer LM or LA becomes an internal layer, said assembly being obtained either continuously by passing the materials to be assembled in the form of a strip between pressing cylinders, or discontinuously by means of a press with the materials to be assembled being cut out into formats, with an assembly pressure of between 1 and 100 MPa and an assembly temperature of less than 600°C in the case of a bonding layer LM and less than 300°C in the case of a bonding layer LA.

21. A process for the production of multi-layer material according to either one of Claims 14 or 15, wherein the adhesive is applied, preferably using a screen printing technique, as a layer which is discontinuous but uniformly distributed, preferably in the form of a fine-mesh grid, in such a way as to give a degree of covering of the surface to be covered of between 5 and 50%.

22. Use of the multi-layer materials according to any one of Claims 1 to 15 for the production of sealing joints.

23. Use of the multi-layer materials according to any one of Claims 1 to 15 for electromagnetic shielding.

24. Use of multi-layer materials according to any one of Claims 1 to 15 for the production of heat sinks.

## Patentansprüche

1. Mehrschichtmaterial, das aus wenigstens zwei Schichten aus schmiegsamem Material besteht, wovon die eine, mit "C" bezeichnete auf Basis von rekomprimiertem expandiertem Graphit ist und die andere eine Metallschicht ist,
dadurch gekennzeichnet,
daß wenigstens eine der beiden Oberflächen der Schicht aus C-Material auf Basis von schmiegsamem, elektrisch leitendem Graphit an jedem Punkt ihrer Oberfläche mit einer Metallschicht M bedeckt und im direkten elektrischen Kontakt mit dieser Metallschicht M ist,
daß diese Metallschicht M durch Elektroabscheidung oder durch chemische Abscheidung von Metall M auf der Schicht aus Material C derart erhalten wird, daß das Material M direkt an der Schicht aus Material C unter Anschluß an das Mikrorelief haftet und eine höhere Haftung an der Schicht aus Material C als die innere Kohäsion der C-Materialschicht aufweist.

2. Mehrschichtmaterial nach dem Anspruch 1, bei dem das schmiegsame Material C schmiegsamer Graphit einer Dichte zwischen 0,3 und 1,5 als Schicht einer Dicke zwischen 0,1 und 10 mm ist.

3. Mehrschichtmaterial nach dem Anspruch 2, bei dem die Metallschicht M aus einem oder mehreren auf chemischem oder elektrochemischem Wege abscheidbaren Metallen besteht.

4. Mehrschichtmaterial nach dem Anspruch 3, bei dem die Dicke der Schicht aus abgeschiedenem Metall zwischen 1 und 200 µm und vorzugsweise zwischen 3 und 50 µm ist.

5. Mehrschichtmaterial nach dem Anspruch 4, bei dem das Metall M Nickel oder Kupfer ist.

6. Mehrschichtmaterial nach irgendeinem der Ansprüche 1 bis 5, dessen wenigstens eine Oberfläche mit einer Bindemittelschicht L derart überzogen ist, um diese Oberfläche mit einer anderen Schicht aus Metall M oder schmiegsamem Material C fest verbinden zu können.

7. Mehrschichtmaterial nach dem Anspruch 6, bei dem die Bindemittelschicht L eine Dicke zwischen 1 und 10 µm hat.

8. Mehrschichtmaterial nach dem Anspruch 7, bei dem die Bindemittelschicht L aus einem Metall LM mit einem Schmelzpunkt unter dem des zur Verstärkung dienenden Metalls M besteht, das auf jede bekannte Art auf wenigstens einer Oberfläche der Mehrschichtmaterialien C/M oder M/C/M derart abgeschieden wird, um eines der folgenden Mehrschichtmaterialien zu erhalten: C/M/LM, LM/C/M, LM/C/M/LM, LM/M/C/M, LM/M/C/M/LM.

9. Mehrschichtmaterial nach dem Anspruch 8, bei dem wenigstens eine Bindemittelschicht LM mit einer Schicht aus schmiegsamem Material C derart überzogen wird, um direkt oder nach Zusammensetzen eines der folgenden Mehrschichtmaterialien zu erhalten: C/M/LM/C, C/LM/C/M, C/LM/C/M/LM/C, C/LM/M/C/M, C/LM/M/C/M/LM/C, C/M/LM/M/C, C/M/LM/C/LM/M/C, C/M/LM/C/M/LM/C, C/LM/C/M/LM, C/LM/M/C/LM.

10. Mehrschichtmaterial nach irgendeinem der Ansprüche 7, 8 oder 9, bei dem das Bindemittelmetall LM Zinn ist.

11. Mehrschichtmaterial nach dem Anspruch 7, bei dem die Bindemittelschicht L eine Kleberschicht LA ist, die sich zum Verkleben der Metallschicht M und der Schicht aus schmiegsamem Metall C eignet und wenigstens eine Oberfläche der Mehrschichtmaterialien C/M oder M/C/M derart bedeckt, um eines der folgenden Mehrschichtmaterialien zu erhalten: LA/C/M, C/M/LA, LA/C/M/LA, LA/M/C/M, LA/M/C/M/LA.

12. Mehrschichtmaterial nach dem Anspruch 11, bei dem jede Bindemittelschicht LA mit einer Schicht aus schmiegsamem Material C derart überzogen wird, um direkt oder durch Zusammensetzen eines der folgenden Mehrschichtmaterialien zu erhalten: C/LA/C/M, C/M/LA/C, C/LA/C/M/LA/C, C/LA/M/C/M, C/LA/M/C/M/LA/C.

13. Mehrschichtmaterial nach irgendeinem der Ansprüche 11 oder 12, bei dem der Kleber LA auf Basis von Phenol-, Epoxy-, Polyimid-, Acryl- oder Polyurethanharz ist.

14. Mehrschichtmaterial nach irgendeinem der Ansprüche 1 bis 13, dessen eine Oberfläche mit einer Kleberaußenschicht, die vom "hot-melt"-Typ sein kann, einer Dicke zwischen 1 und 10 µm überzogen wird, die dazu bestimmt ist, das Mehrschichtmaterial mit dem Endträger, auf dem es zwecks seiner Verwendung angebracht wird, fest zu verbinden.

15. Mehrschichtmaterial nach dem Anspruch 14, dessen Kleberaußenschicht mit einem abschälbaren Film aus an sich selbst nicht klebenden Material, vorzugsweise aus Papier oder einem Kunststoffilm, derart überzogen wird, um die Klebfunktion einer Oberfläche des Mehrschichtmaterials erst im Augenblick seiner Anbringung auf dem Endträger unter Entfernung des abschälbaren Films auftreten zu lassen.

16. Verfahren zur Herstellung von Mehrschichtmaterial nach irgendeinem der Ansprüche 1 bis 5, bei dem man kontinuierlich das Metall M durch Elektroabscheidung oder auf chemischem Wege auf wenigstens einer Oberfläche eines Bandes aus schmiegsamem Material C einer 1 m übersteigen könnenden Breite mit einer automatischen Regulierung und Steuerung der chemischen und/oder elektrischen Parameter des Bades sowie der Durchlaufgeschwindigkeit des Bandes derart abscheidet, um eine Metallschicht M einer regelmäßigen und vorbestimmten Dicke zu erhalten.

17. Verfahren zur Herstellung von Mehrschichtmaterial nach irgendeinem der Ansprüche 8 und 10, bei dem man kontinuierlich und mit einer Steuerung und Regulierung der abgeschiedenen Dicke das Bindemittelmetall LM durch Elektroabscheidung oder auf chemischem Wege auf wenigstens einer Oberfläche von mehrschichtigem Material C/M oder M/C/M als Band einer 1 m übersteigen könnenden Breite abscheidet.

18. Verfahren zur Herstellung von Mehrschichtmaterial nach irgendeinem der Ansprüche 11 und 13, bei dem man kontinuierlich und mit einer Steuerung und Regulierung der abgeschiedenen Dicke eine Kleberschicht LA nach jedem bekannten Verfahren und vorzugsweise durch Aufstreichen oder Aufstäuben auf wenigstens einer Oberfläche von Mehrschichtmaterial C/M oder M/C/M als Band einer 1 m übersteigen könnenden Breite abscheidet.

19. Herstellungsverfahren nach dem Anspruch 18, bei dem man, vorzugsweise nach einem serigraphischen Verfahren, eine diskontinuierliche, jedoch gleichmäßig verteilte Kleberschicht, vorzugsweise mit dem Aussehen eines Netzes mit feiner Maschenweite, derart abscheidet, um einen Bedeckungsgrad durch den Kleber LA zwischen 5 und 50 % der zu bedeckenden Oberfläche abscheidet.

20. Verfahren zur Herstellung von Mehrschichtmaterial nach irgendeinem der Ansprüche 9 oder 12, bei dem man das Zusammensetzen eines Mehrschichtmaterials, von dem wenigstens eine Oberfläche aus einer Bindemittelschicht LM oder LA besteht, mit wenigstens einer Schicht aus schmiegsamem Material C oder eventuell mit sich selber derart durchführt, daß die Bindemittelschicht LM oder LA eine innere Schicht wird, wobei das Zusammensetzen entweder kontinuierlich mittels Durchgangs der zusammenzusetzenden Materialien in Bandform zwischen Druckzylindern oder diskontinuierlich in der Presse mit den in Formate geschnittenen zusammenzusetzenden Materialien mit einem Zusammensetzungsdruck zwischen 1 und 100 MPa und einer Zusammensetzungstemperatur unter 600 °C im Fall einer Bindemittelschicht LM und unter 300 °C im Fall einer Bindemittelschicht LA erhalten wird.

21. Verfahren zur Herstellung von Mehrschichtmaterial nach irgendeinem der Ansprüche 14 oder 15, bei dem der Kleber, vorzugsweise nach einer serigraphischen Technik, als diskontinuierliche, jedoch regelmäßig verteilte Schicht, vorzugsweise mit dem Aussehen eines Netzes feiner Maschenweite, derart aufgebracht wird, um einen Bedeckungsgrad zwischen 5 und 50 % der zu überziehenden Oberfläche zu haben.

22. Verwendung der Mehrschichtmaterialien nach irgendeinem der Ansprüche 1 bis 15 zur Herstellung von Abdichtungsbauteilen.

23. Verwendung der Mehrschichtmaterialien nach irgendeinem der Ansprüche 1 bis 15 zur elektromagnetischen Abschirmung.

24. Verwendung der Mehrschichtmaterialien nach irgendeinem der Ansprüche 1 bis 15 zur Herstellung von Wärmeableitungen.
